# EUROPEAN PATENT APPLICATION

(11) **EP 2 871 687 A2**
(43) Date of publication of application: **13.05.2015**
(21) Application number: 14191817.7
(22) Date of filing: 05.11.2014
(51) Int. Cl.: H01L 51/50, H01L 51/52

(54) **Organic light emitting device**

(30) Priority: 07.11.2013 US 201361901039 P; 29.07.2014 US 201414445672
(71) Applicant: Industrial Technology Research Institute, Chutung Hsinchu 31040 (TW)
(72) Inventor: Liu, Chun-Ting, 308 Hsinchu County (TW); Yeh, Wen-Yung, 303 Hsinchu County (TW); Yen, Hsi-Hsuan, 106 Taipei City (TW)
(74) Representative: Krauns, Christian

(57) **Abstract**

An organic light emitting device (OLED) is provided, comprising a first electrode (11) and a second electrode (12) disposed oppositely, and an organic light emitting (EL) layer (15) formed between the first electrode and the second electrode, wherein the EL layer comprises at least one organic light emitting material. In one embodiment, the EL layer is a dipole controlled organic light emitting layer, and the longest axes of organic molecules (151) of the organic light emitting material or exciton dipole moments of the organic molecules are anisotropically oriented, such as arranged as an anisotropic array, for decreasing the possibility of exciton energy directly coupled into the cathode. In an alternative embodiment, a periodic array of nano-grating structure is formed between the first and second electrodes for decreasing the possibility of propagation of the TM polarized light. Accordingly, the light efficiency of the OLED is significantly improved.

## Description

### TECHNICAL FIELD

The disclosure relates in general to an organic light emitting device, and more particularly to an organic light emitting device with improved light efficiency.

### BACKGROUND

An organic light emitting device, also called an OLED, are attractive because of their low drive voltage, high luminance, wide viewing angle, and capability for full color flat emission displays and for other applications. Also, OLED is capable of providing the full spectrum light which is closest to natural lighting. With those special properties, OLED has become increasingly interesting technology for lighting applications, among other applications.

Notwithstanding all the developments made in the OLED field, there are more continuing needs for OLED devices that provide higher light efficiency. Low SPP (surface plasmon polariton) mode is one of key factors of high light efficiency of an OLED. The less the exciton energy is coupled into the cathode, the more light the OLED discharges.

### SUMMARY

The disclosure is directed to an organic light emitting device, which is designed for decreasing the possibility of exciton energy directly coupled into the cathode or the possibility of propagation of the TM polarized light, thereby significantly increasing the light efficiency of the OLED.

According to one embodiment, an organic light emitting device (OLED) is provided, comprising a first electrode and a second electrode disposed oppositely, and a dipole controlled organic light emitting layer formed between the first electrode and the second electrode. The dipole controlled organic light emitting layer comprises at least one organic light emitting material, and longest axes of organic molecules of the organic light emitting material are arranged as an anisotropic array.

In one embodiment, an organic light emitting device (OLED) may further comprises a periodic array of nano-grating structure formed between the first electrode and the second electrode.

According to another embodiment, an organic light emitting device (OLED) is provided, comprising a first electrode and a second electrode disposed oppositely, and a dipole controlled organic light emitting layer formed between the first electrode and the second electrode. The dipole controlled organic light emitting layer comprises at least one organic light emitting material, and exciton dipole moments of the organic molecules of the organic light emitting material in the dipole controlled organic light emitting layer are anisotropic.

### BRIEF DESCRIPTION OF THE DRAWINGS

FIG. 1 schematically shows a cross-sectional view of an organic light emitting device according to the first embodiment of the disclosure.
FIG. 2A illustrates a coordinate system defining the spatial relationship of the organic molecule skeleton axes in the light emitting layer.
FIG. 2B illustrate a coordinate system defining the spatial relationship of the exciton dipole moment in the light emitting layer.
FIG. 3A schematically illustrates a spatial relationship between the organic molecule in the light emitting layer and a light discharge plane according to the first embodiment of the disclosure.
FIG. 3B schematically illustrates a spatial relationship between the dipole moment in the light emitting layer and a light discharge plane according to the first embodiment of the disclosure.
FIG. 4A ~ FIG. 4F schematically show top views of some applicable anisotropic arrangements of the organic molecules of the organic light emitting layer according to the embodiment.
FIG. 5A schematically shows a cross-sectional view of an organic light emitting device with isotropically oriented organic molecules.
FIG. 5B schematically shows a cross-sectional view of an organic light emitting device with anisotropically oriented organic molecules according to the first embodiment of the disclosure.
FIG. 6 schematically shows a cross-sectional view of an electric field acting on an organic light emitting device according to the first embodiment of the disclosure.
FIG. 7 schematically shows a cross-sectional view of an organic light emitting device according to the second embodiment of the disclosure.
FIG. 8 schematically illustrates a cross-sectional view of an organic light emitting device according to the third embodiment of the disclosure.
FIG. 9A and FIG. 9B schematically illustrate cross-sectional views of two organic light emitting devices according to the fourth embodiment of the disclosure.
FIG. 10 schematically illustrates a cross-sectional view of an organic light emitting device according to the fifth embodiment of the disclosure.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

### DETAILED DESCRIPTION

Below, exemplary embodiments of organic light emitting devices will be described in detail with reference to accompanying drawings so as to be easily realized by a person having ordinary knowledge in the art. The inventive concept may be embodied in various forms without being limited to the exemplary embodiments set forth herein. Descriptions of well-known parts are omitted for clarity, and like reference numerals refer to like elements throughout.

In the embodiments, the organic light emitting device (OLED) with particular designs, such as the OLEDs having the dipole controlled organic light emitting layers (with anisotropically oriented organic molecules or dipole moments) and/or a periodic array of nano-grating structure (functioning as photonic crystals inside) between the opposite electrodes of the device (such as formed in the organic light emitting layer), are provided hereinafter for illustrations. According to the structural designs of the embodiments, it is capable of decreasing the possibility of exciton energy directly coupled into the cathode greatly, and/or decreasing the possibility of propagation of the TM polarized light. Thus, the light efficiency of the OLED can be significantly increased.

Embodiments are provided hereinafter with reference to the accompanying drawings for describing the related configurations and procedures, but the present disclosure is not limited thereto. It is noted that not all embodiments of the invention are shown. Structures of the embodiments would be different, and could be modified and changed optionally according to the design needs of the application. Modifications and variations can be made without departing from the spirit of the disclosure to meet the requirements of the practical applications. Thus, there may be other embodiments of the present disclosure which are not specifically illustrated. It is also important to point out that the illustrations may not be necessarily be drawn to scale. Thus, the specification and the drawings are to be regard as an illustrative sense rather than a restrictive sense.

### <First Embodiment>

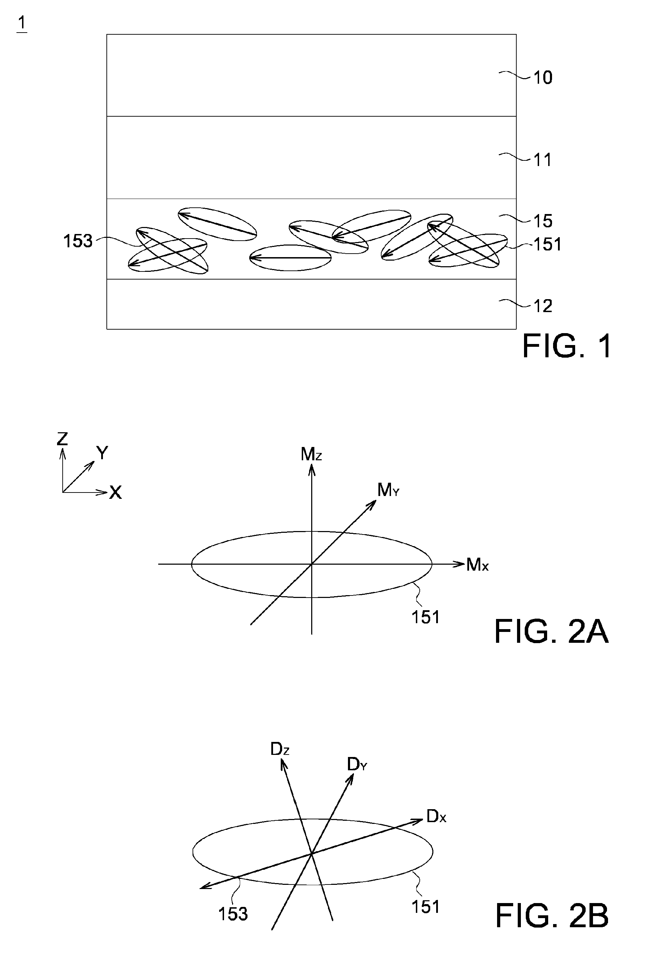

FIG. 1 schematically shows a cross-sectional view of an organic light emitting device according to the first embodiment of the disclosure. According to the first embodiment, an OLED 1 at least comprises a first electrode 11 and a second electrode 12 disposed oppositely, and a dipole controlled organic light emitting layer 15 formed between the first electrode 11 and the second electrode 12. In the OLED of the embodiment, the first electrode 11 can be an anode formed on a substrate 10, while the second electrode 12 can be a cathode formed on the dipole controlled organic light emitting layer 15. The dipole controlled organic light emitting layer 15 comprises at least one organic light emitting material (usually two or more different organic lighting materials), and the organic light emitting material comprises a great number of organic molecules 151.

In the first embodiment, the longest axes of organic molecules 151 of the organic light emitting material are arranged as an anisotropic array. Alternatively, exciton dipole moments 153 of the organic molecules 151 in the dipole controlled organic light emitting layer 15 of the first embodiment are anisotropic, before or after the OLED operation.

FIG. 2A illustrates a coordinate system defining the spatial relationship of the organic molecule skeleton axes in the light emitting layer. FIG. 2B illustrate a coordinate system defining the spatial relationship of the exciton dipole moment in the light emitting layer. In the dipole controlled organic light emitting layer 15, the orientational axes of the organic molecule 151 of the organic light emitting material can be defined as Mx, My and Mz. As shown in FIG. 2A, the direction of the longest axis (or major axis) of the organic molecule 151 is Mx, and the direction of the short axis (or minor axis) of the organic molecule 151 is My. The remaining axis of the organic molecule 151 on the left hand side in the direction vertical to the Mx and My axes is the Mz axis. Also, the direction of the dipole moment 153 of the light emission is along the Dx axis, and the direction vertical to the Dx axis where light is radiated most heavily is along the Dz axis. The remaining axis on the left hand side in the direction vertical to the Dx and Dz axes is the Dy axis.

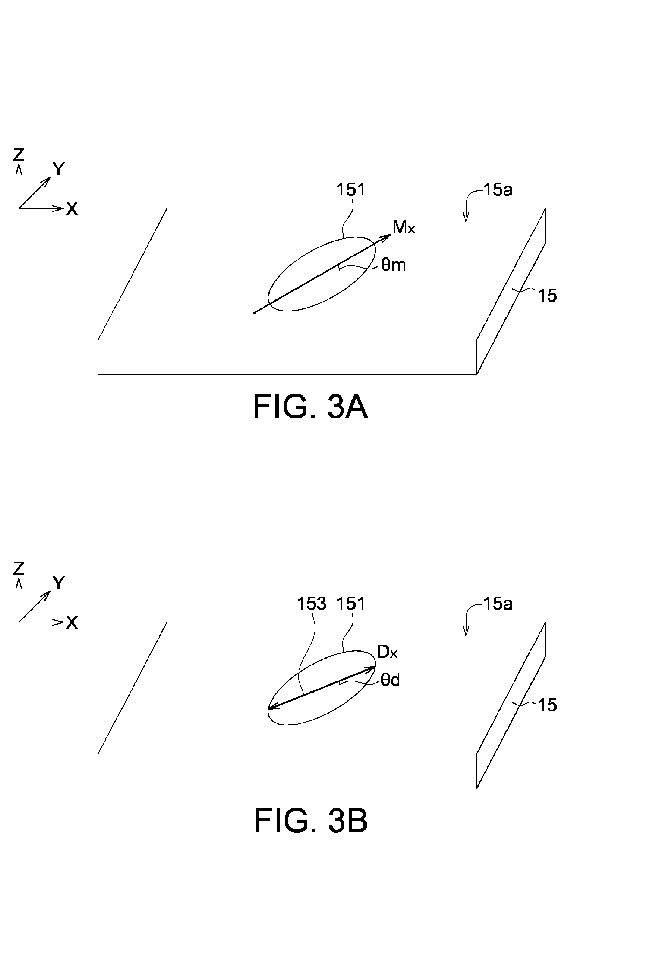

FIG. 3A schematically illustrates a spatial relationship between the organic molecule in the light emitting layer and a light discharge plane according to the first embodiment of the disclosure. FIG. 3B schematically illustrates a spatial relationship between the dipole moment in the light emitting layer and a light discharge plane according to the first embodiment of the disclosure. It is assumed that the light discharge plane of the embodiment is the top surface 15a of the dipole controlled organic light emitting layer 15 facing the first electrode 11. In FIG. 3A, the organic molecule 151 leans to the top surface 15a of the dipole controlled organic light emitting layer 15 at an angle of θ*m.* In FIG. 3B, the dipole moment 153 leans to the top surface 15a of the dipole controlled organic light emitting layer 15 at an angle of θ*d*.

The organic molecules 151 of the dipole controlled organic light emitting layer 15 can be anisotropically oriented, and the organic molecules 151 is leaned toward to the light discharge plane of the OLED for decreasing the possibility of exciton energy directly coupled into the second electrode 12 (ex: cathode). Please refer to FIG. 1, FIG. 2A and FIG. 3A. In one embodiment, the longest axes, Mx, of the anisotropically oriented organic molecules 151 of the organic light emitting material of the dipole controlled organic light emitting layer 15 are substantially oriented within an angular range from 0 to less than 45 degrees with respect to an extending direction of the first electrode 11 and an extending direction of a light discharge plane (i.e. the top surface 15a) of the OLED (0 degree <θ*m* < 45 degrees). The extending direction of the light discharge plane is parallel to the xy-plane. In one embodiment, the longest axes, Mx, of the anisotropically oriented organic molecules 151 are substantially oriented within an angular range from 0 to 15 degrees with respect to an extending direction of the first electrode 11 and an extending direction of a light discharge plane (i.e. the top surface 15a) of the OLED (0 degree ≤θ*m* ≤ 15 degrees). It is more ideally that the longest axes, Mx, of the anisotropically oriented organic molecules 151 of the first embodiment are substantially parallel to the first electrode 11 and the light discharge plane (i.e. the top surface 15a) of the OLED.

Alternatively, the exciton dipole moments 153 in the dipole controlled organic light emitting layer 15 can be anisotropically oriented, and the exciton dipole moments 153 is leaned toward to the light discharge plane of the OLED for decreasing the possibility of exciton energy directly coupled into the second electrode 12 (ex: cathode). Please refer to FIG. 1, FIG. 2B and FIG. 3B. In one embodiment, the directions of the dipole moments 153, Dx, of the dipole controlled organic light emitting layer 15 are substantially oriented within an angular range from 0 to less than 45 degrees with respect to an extending direction of the first electrode 11 and an extending direction of a light discharge plane (i.e. the top surface 15a) of the OLED (0 degree ≤θ*d* < 45 degrees). In one embodiment, the directions of the dipole moments 153, Dx, of the organic molecules 151 are substantially oriented within an angular range from 0 to 15 degrees with respect to an extending direction of the first electrode 11 and an extending direction of the light discharge plane of the OLED (0 degree ≤θ*d* ≤ 15 degrees). It is more ideally that the directions of the dipole moments 153, Dx, of the dipole controlled organic light emitting layer 15 of the first embodiment are substantially parallel to the first electrode 11 and the light discharge plane (i.e. top surface 15a) of the OLED.

In one embodiment, an angle *(*θ*m*) of the longest axes of the organic molecules 151 with respect to an extending direction of the first electrode 11 can be equal to an angle (θ*d*) of said exciton dipole moments 153 of the organic molecules 151 with respect to the extending direction of the first electrode 11. In alternative embodiment, an angle (θ*m*) of the longest axes of the organic molecules 151 with respect to an extending direction of the first electrode 11 can be different from an angle (θ*d*) of said exciton dipole moments 153 of the organic molecules 151 with respect to the extending direction of the first electrode 11, which means an angle exists between the exciton dipole moments 153 and the longest axes of the organic molecules 151.

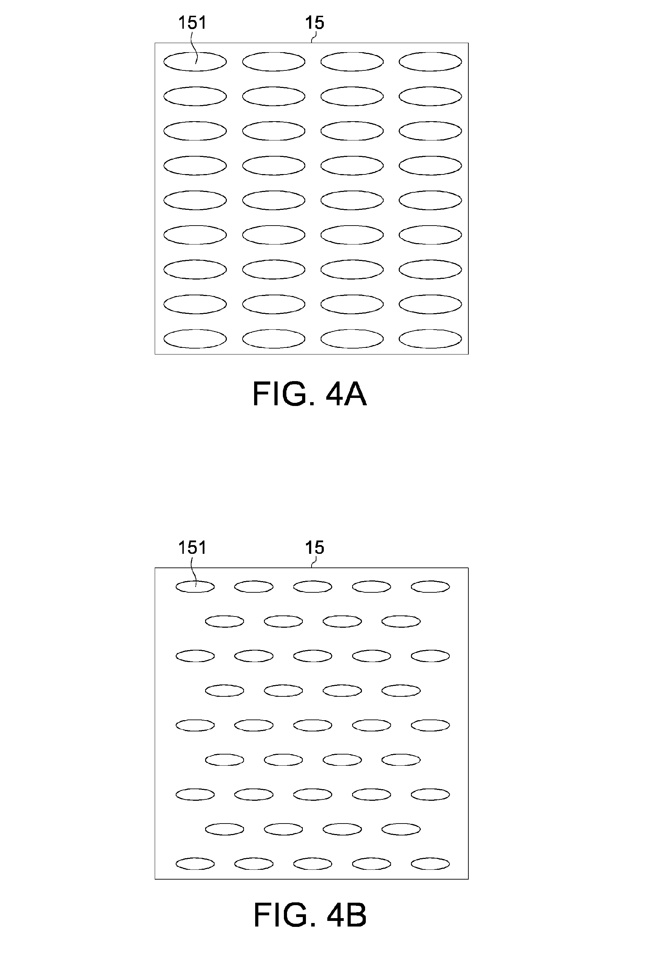

According to the embodiment, the organic molecules 151 of the organic light emitting material or the dipole moments 153 of the organic light emitting layer 15 exhibit an orderly arrangement such as anisotropically arranged, in order to prevent exciton energy from transferring into the SPP (surface plasmon polariton) mode, thereby decreasing the possibility of exciton energy directly coupled into the cathode. Low SPP mode is one of key factors of high light efficiency of an OLED. There are a variety of orderly arrangements for anisotropic orientation of the organic molecules 151 and/or the dipole moments 153 in the applications. FIG. 4A ~ FIG. 4F schematically show top views of some applicable anisotropic arrangements of the organic molecules of the organic light emitting layer according to the embodiment.

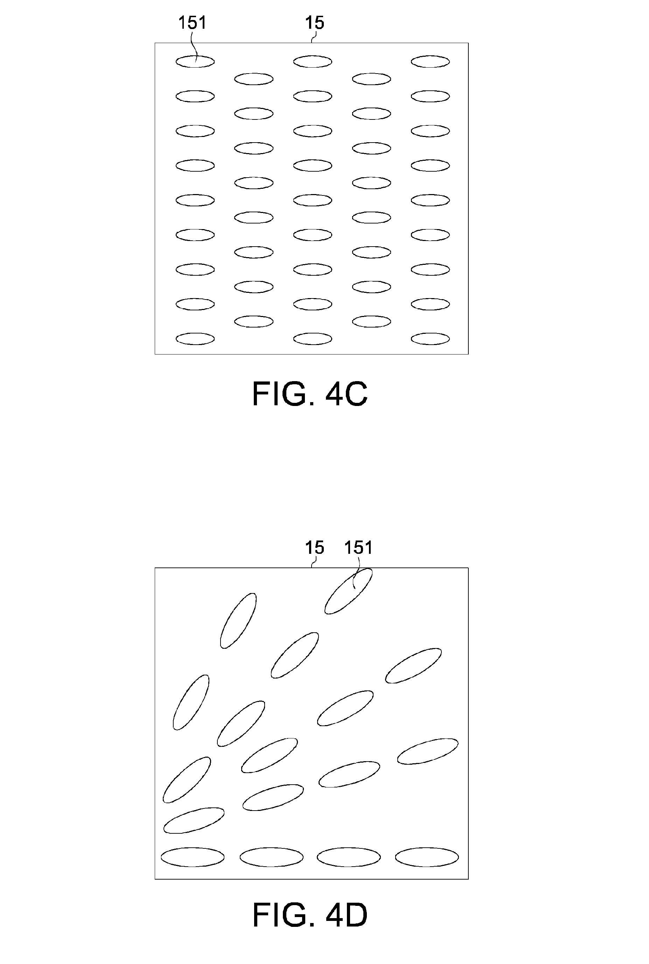

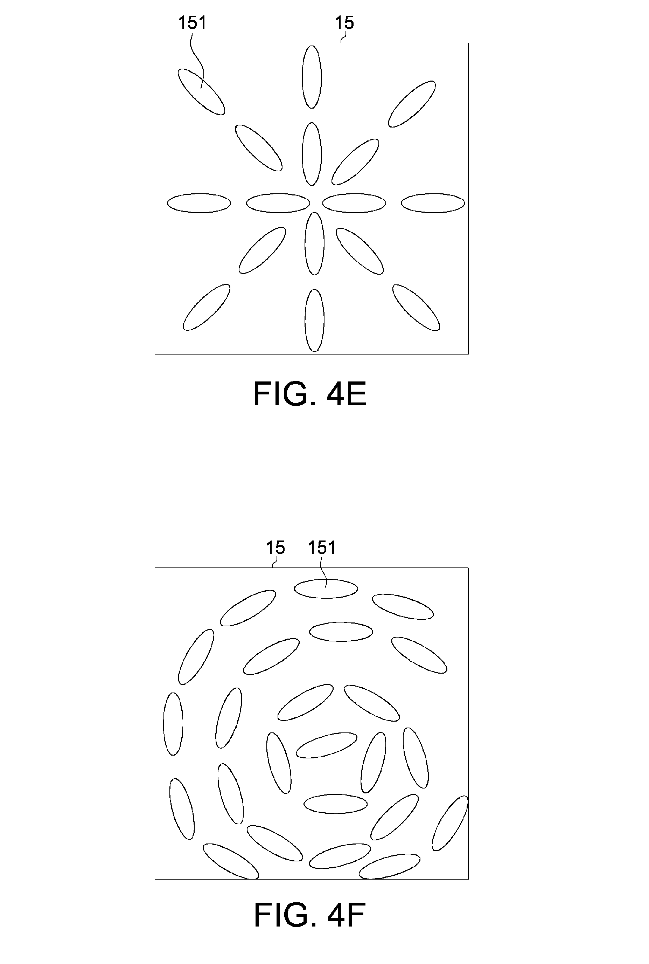

As shown in FIG. 4A, the longest axes (Mx) of the organic molecules 151 of the organic light emitting material can be anisotropically arranged as an array of matrix, from the top view of the OLED. As shown in FIG. 4B, the longest axes (Mx) of the organic molecules 151 of the organic light emitting material can be anisotropically arranged as a pattern with columns in parallel, and the organic molecules 151 in adjacent rows are staggered. As shown in FIG. 4C, the longest axes (Mx) of the organic molecules 151 of the organic light emitting material can be anisotropically arranged as a pattern with rows in parallel, and the organic molecules 151 in adjacent columns are staggered. Also, the longest axes (Mx) of the organic molecules 151 of the organic light emitting material can be anisotropically arranged as a radiation pattern. As shown in FIG. 4D, a radiation center of the radiation pattern is substantially positioned adjacent to or closed to a corner of the light emitting layer, such as adjacent to the left downward corner of the dipole controlled organic light emitting layer 15. Alternatively, a radiation center of the radiation pattern is substantially positioned adjacent to or closed to a center of the light emitting layer, as shown in FIG. 4E. Additionally, the longest axes (Mx) of the organic molecules 151 of the organic light emitting material can be anisotropically arranged as a spiral pattern, as shown in FIG. 4F.

Similarly, the dipole moments 153 of the embodiment can exhibit the anisotropic arrangements as exemplified by a pattern with rows in parallel, a pattern with columns in parallel, an array of matrix, a radiation pattern, a spiral pattern in respective FIG. 4A ~ FIG. 4F, or the like. Noted that FIG. 4A ~ FIG. 4F are not all the applicable anisotropic arrangements of the organic molecules 151 and/or the dipole moments 153 in the embodiment. Other anisotropic arrangements would be applicable, and could be modified and changed optionally according to the design conditions of the application. Thus, the present disclosure is not limited to those configurations

According to the embodiment, the anisotropic orientation of the organic molecules 151 and/or the dipole moments 153 can be formed by applying an action at a distance, such as providing a magnetic field or an electrical field in the procedures of fabricating the dipole controlled organic light emitting layer 15. For example, the organic molecules 151 can be anisotropically oriented by introducing a magnetic field or an electrical field to the environment for depositing, coating or material mixing of the organic light emitting layer 15.

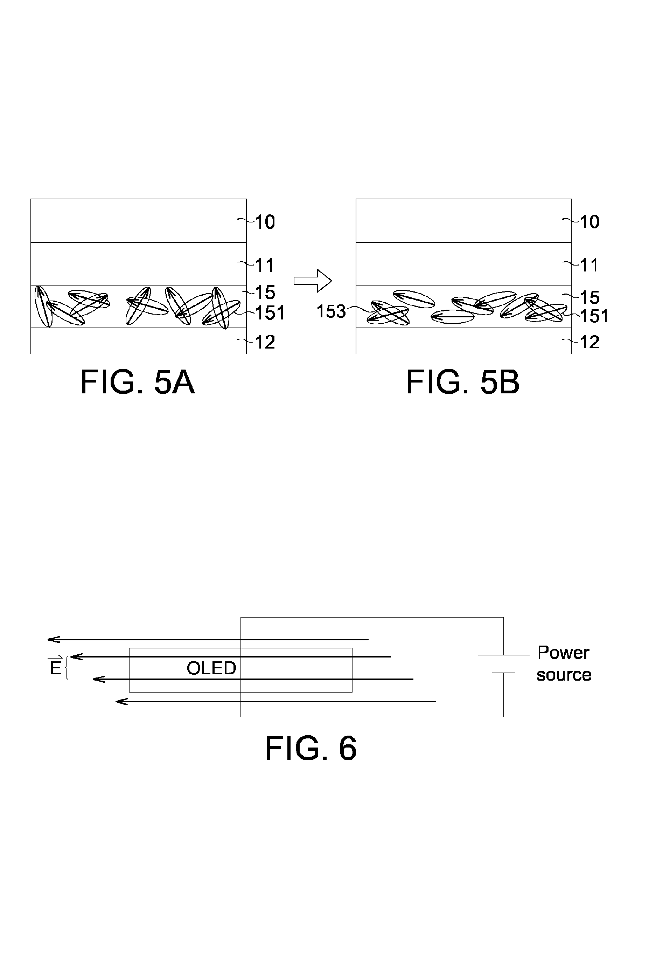

FIG. 5A schematically shows a cross-sectional view of an organic light emitting device with isotropically oriented organic molecules. In FIG. 5A, the distribution of the organic molecules 151 are directionally independent. FIG. 5B schematically shows a cross-sectional view of an organic light emitting device with anisotropically oriented organic molecules according to the first embodiment of the disclosure. In FIG. 5B, the distribution of the organic molecules 151 are directionally dependent. In one embodiment, the organic molecules 151 are isotropically oriented (FIG. 5A) before applying a magnetic field or an electrical field in the fabricating procedures of the organic light emitting layer 15, and would be anisotropically oriented after action of the magnetic or electrical field on the organic light emitting layer 15. After the fabrication of the organic light emitting layer 15 is done, the organic molecules 151 and/or the dipole moments 153 of the embodiment would be anisotropic permanently.

Alternatively, the anisotropic orientation of the organic molecules 151 and/or the dipole moments 153 can be formed during the OLED operation. FIG. 6 schematically shows a cross-sectional view of an electric field acting on an organic light emitting device according to the first embodiment of the disclosure. During operation of OLED, an action at a distance, such as an electrical field as shown in FIG. 6 or a magnetic field, is applied for inducing the anisotropic orientation of the organic molecules 151 and/or the dipole moments 153 of the dipole controlled organic light emitting layer 15. In this case, the anisotropic orientation of the organic molecules 151 and/or the dipole moments 153 are not existed permanently, and only presented when the OLED is operated. Similarly, the isotropically oriented organic molecules 151 before OLED operation can be referred to the illustration of FIG. 5A, while the anisotropically oriented organic molecules 151 after OLED operation can be referred to the illustration of FIG. 5B.

Thus, anisotropically oriented the organic molecules 151 and/or the dipole moments 153 of the embodiment can be presented before or after the OLED operation, and the present disclosure has no particular limitation thereto.

### <Second Embodiment>

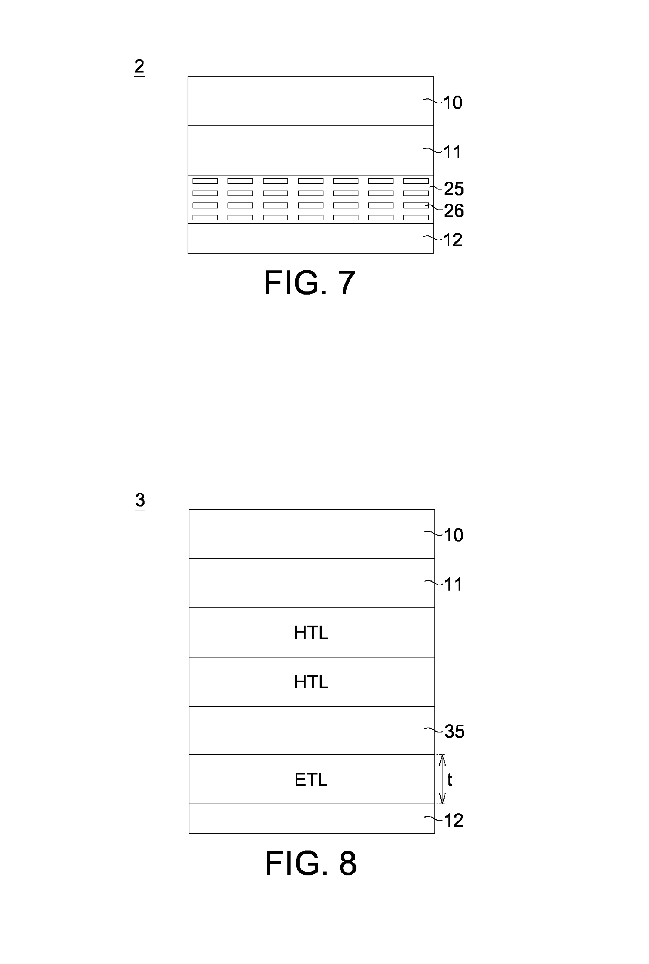

FIG. 7 schematically shows a cross-sectional view of an organic light emitting device according to the second embodiment of the disclosure. Identical elements of the second and the first embodiments, such as the substrate 10, the first electrode 11, and the second electrode 12, are designated with the same reference numerals, and details of the same elements described in the first embodiment are not redundantly repeated herein.

In the second embodiment, an OLED 2 at least comprises a first electrode 11 and a second electrode 12 disposed oppositely, an organic light emitting layer 25 formed between the first electrode 11 and the second electrode 12, and a periodic array of nano-grating structure 26 formed between the first electrode 11 and the second electrode 12. In one embodiment, the periodic array of nano-grating structure 26 can be, but not limitedly, formed in the organic light emitting layer 25, as depicted in FIG. 7. In one embodiment, the periodic array of nano-grating structure 26 as shown in FIG. 7 functions as a structure of photonic crystals. It is noted that the present disclosure is not limited to the configuration of FIG. 7. Other periodic arrays resulting in a photonic bandgap able to block the TM polarized light are also applicable in the OLED of the second embodiment.

Generally, the propagating direction of TM polarized light is parallel to the extending direction of the first electrode 11, or parallel to the extending direction of a light discharge plane (ex: to surface of organic light emitting layer 25) of the OLED. The propagating direction of TE polarized light is perpendicular to the extending direction of the first electrode, or perpendicular to the extending direction of the light discharge plane of the OLED. For an OLED of the second embodiment, the periodic array of nano-grating structure 26 is a periodic array resulting in a photonic bandgap, and a range of frequency within which a specific wavelength of light, such as TM polarized light can be blocked. Therefore, the periodic array of nano-grating structure 26 in the organic light emitting layer 25 according to the second embodiment allows TE polarized light to propagate into the periodic array (photonic crystals) and through the organic light emitting layer 25, but inhibits even prevents the propagation of the TM polarized light.

In the second embodiment, since the periodic array of nano-grating structure 26 in the organic light emitting layer 25 inhibits and/or prevents the propagation of the TM polarized light, more light energy would be saved for TE polarization. Therefore, the ratio of TM polarization to TE polarization is significantly decreased. In one embodiment, the ratio of TM polarization to TE polarization is about 0.1 or less. Less or no TE polarized light is generated and/or propagated, and the possibility of exciton energy of TE polarized light coupled into the cathode (ex: the second electrode 12) is decreased consequently, Thus, the light efficiency of the OLED of the second embodiment can be significantly improved.

In an alternative embodiment, an organic light emitting layer of an organic light emitting device may comprise the periodic array of nano-grating structure 26 as described in the second embodiment, and the anisotropically oriented organic molecules 151 and/or dipole moments 153 as described in the first embodiment, to ensure the decrease of the possibility of exciton energy coupled into the cathode.

### <Third Embodiment>

FIG. 8 schematically illustrates a cross-sectional view of an organic light emitting device according to the third embodiment of the disclosure. Identical elements of the third and the first embodiments, such as the substrate 10, the first electrode 11, and the second electrode 12, are designated with the same reference numerals, and details of the same elements described in the first embodiment are not redundantly repeated herein.

In the third embodiment, an OLED further comprises an electron-transporting layer (ETL) formed between the second electrode (ex: cathode) 12 and the organic light emitting layer 35. The organic light emitting layer 35 could be the dipole controlled organic light emitting layer 15 comprising anisotropically oriented organic molecules 151 and/or dipole moments 153 as described in the first embodiment, or the periodic array of nano-grating structure 26 as described in the second embodiment, or both.

Besides the ETL, other layers typically adopted in the OLED could be constructed optionally, but not limitedly. As shown in FIG. 8, an OLED 3 may comprise the first electrode (ex: anode) 11 formed on the substrate 10, a hole-injecting layer (HIL) formed on the first electrode 11, a hole-transporting layer (HTL) formed on the HIL, the organic light emitting layer 35 formed on the HTL, an electron-transporting layer (ETL) formed on the organic light emitting layer 35, wherein the organic light emitting layer 35 is positioned between the second electrode 12 and the ETL.

In one embodiment, the ETL has a thickness in a range of about 2nm to about 200nm.

According to the third embodiment, the electron-transporting layer (ETL) is formed between the second electrode (ex: cathode) and the organic light emitting layer 35 for further decreasing the possibility of exciton energy coupled into the cathode, thereby achieving a higher light efficiency of the embodied OLED.

### <Fourth Embodiment>

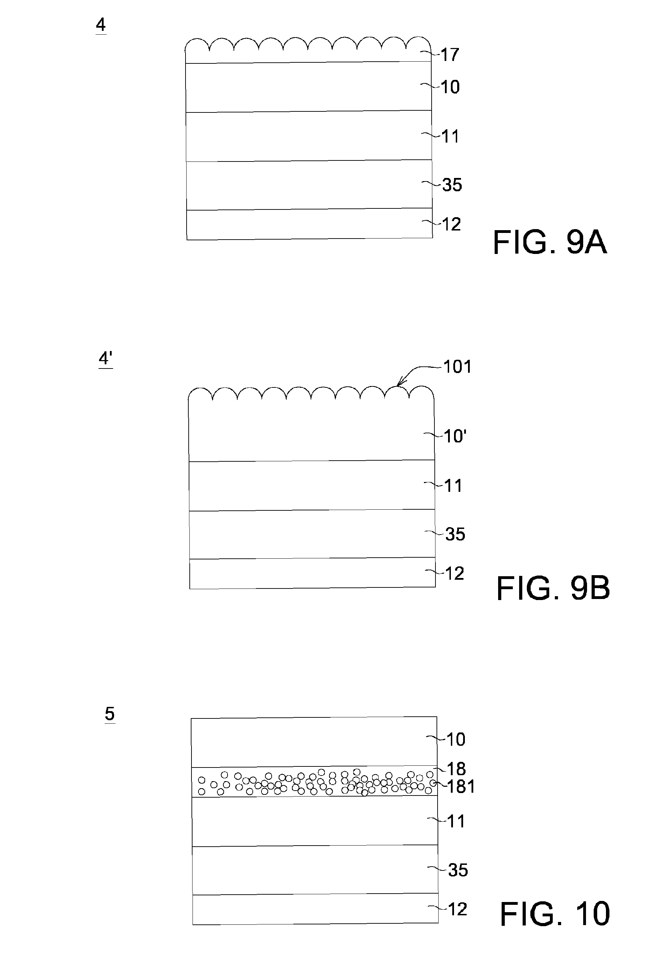

FIG. 9A and FIG. 9B schematically illustrate cross-sectional views of two organic light emitting devices according to the fourth embodiment of the disclosure. Identical elements of the fourth and the first embodiments, such as the substrate 10, the first electrode 11, and the second electrode 12, are designated with the same reference numerals, and details of the same elements described in the first embodiment are not redundantly repeated herein. Similarly, the organic light emitting layer 35 of the fourth embodiment could be the dipole controlled organic light emitting layer 15 comprising anisotropically oriented organic molecules 151 and/or dipole moments 153 as described in the first embodiment, or the periodic array of nano-grating structure 26 as described in the second embodiment, or both.

In the fourth embodiment, a side of the substrate 10 opposite to the first electrode 11 may have a light dispersion surface, by laminating an extra light dispersion layer 17 on the substrate 10 (FIG. 9A) or patterning one surface of the substrate 10' to form a light dispersion plane 101 (FIG. 9B).

As shown in FIG. 9A, an OLED further comprises a light dispersion layer 17 laminated on one side of the substrate 10 opposite to the first electrode 11 for guiding the light emitted from the organic light emitting layer 35 upwardly. In one embodiment, the light dispersion layer 17 comprises an array of micro-optical components. The array of micro-optical components is a periodic pattern such as an array of micro lens, or micro bumps, or micro pillars or the like. The light dispersion layer 17 makes it possible to take out a greater amount of light.

Also, the light dispersion layer 17 can be made from a material different from the substrate 10. In one embodiment, a refractive index of the light dispersion layer 17 is higher than a refractive index of the substrate 10 to ensure the light to be discharged out of the device efficiently.

As shown in FIG. 9B, one side of the substrate 10' is a light dispersion plane 101 comprising a plurality of micro-optical components. The micro-optical components can be configured as an array of micro lens or micro bumps, or micro pillars or the like. Similarly, the light dispersion plane 101 of the substrate 10' guides the light emitted from the organic light emitting layer 35 upwardly, which makes it possible to take out a greater amount of light.

### <Fifth Embodiment>

FIG. 10 schematically illustrates a cross-sectional view of an organic light emitting device according to the fifth embodiment of the disclosure. Identical elements of the fifth and the first/fourth embodiments, such as the substrate 10, the first electrode 11, and the second electrode 12, are designated with the same reference numerals, and details are not redundantly repeated herein. Similarly, the organic light emitting layer 35 of the fifth embodiment could be the dipole controlled organic light emitting layer 15 comprising anisotropically oriented organic molecules 151 and/or dipole moments 153 as described in the first embodiment, or the periodic array of nano-grating structure 26 as described in the second embodiment, or both.

In the fifth embodiment, an OLED 5 further comprises an intermediate layer 18 disposed between the substrate 10 and the first electrode 11, and a plurality of light-scattering particles 181 are distributed in the intermediate layer 18 for scattering light. According to the fifth embodiment, the light-scattering particles 181 distributed in the intermediate layer 18 help to guide the light emitted from the organic light emitting layer 35 upwardly, which also makes it possible to take out a greater amount of light.

Additionally, a substrate with a high refractive index can be adopted in the OLED of the embodiment, to ensure the light to be discharged out of the device efficiently. In one embodiment, a substrate 10/10' of an embodied OLED has a high refractive index higher than that of the first electrode 11. In one embodiment, a substrate 10/10' of an embodied OLED has a high refractive index n larger than 1.5, such as in a range of larger than 1.5 to 2.0. In one embodiment, the first electrode 11 can be an ITO having a refractive index of about 1.9, and the substrate 10 having a refractive index of larger than about 1.5. In one embodiment, a substrate 10/10' of an embodied OLED has a high refractive index n equal to or larger than 1.9.

According to the aforementioned descriptions, an organic light emitting device (OLED) of the embodiment could comprise an organic light emitting layer with anisotropically oriented organic molecules or dipole moments (to form a dipole controlled organic light emitting layer), and/or with a periodic array of nano-grating structure (ex: functioning as photonic crystals) contained inside, or both. In one of the embodiments, the organic molecules of the organic light emitting material or the dipole moments of the organic light emitting layer exhibit an orderly arrangement such as anisotropically arranged, in order to prevent exciton energy from transferring into the SPP mode, thereby decreasing the possibility of exciton energy directly coupled into the cathode. In one of the embodiments, the periodic array of nano-grating structure between the first and second electrodes (ex: in the organic light emitting layer) inhibits generation and propagation of TM polarized light in the organic light emitting layer. According to the structural designs of the embodiments, it is capable of decreasing the possibility of exciton energy directly coupled into the cathode. Thus, the light efficiency of the OLED can be significantly increased.

It will be apparent to those skilled in the art that various modifications and variations can be made to the disclosed embodiments. It is intended that the specification and examples be considered as exemplary only, with a true scope of the disclosure being indicated by the following claims and their equivalents.

## Claims

1. An organic light emitting device, comprising:
a first electrode (11) and a second electrode (12) disposed oppositely; and
a dipole controlled organic light emitting layer (15), formed between the first electrode and the second electrode, and the dipole controlled organic light emitting layer comprising at least one organic light emitting material, wherein longest axes (Mx) of organic molecules (151) of the organic light emitting material are oriented as an anisotropic array.

2. The organic light emitting device according to claim 1, wherein said longest axes of the organic molecules of the organic light emitting material are substantially oriented within an angular range from 0 to 15 degrees with respect to an extending direction of the first electrode.

3. The organic light emitting device according to claim 1 or 2, wherein said longest axes of the organic molecules of the organic light emitting material are substantially parallel to the first electrode.

4. The organic light emitting device according to any one of claims 1 to 3, wherein said longest axes of the organic molecules of the organic light emitting material are anisotropically oriented as a pattern with rows in parallel, a pattern with columns in parallel, an array of matrix, a radiation pattern, or a spiral pattern.

5. The organic light emitting device according to any one of claims 1 to 4, wherein exciton dipole moments of the organic molecules in the dipole controlled organic light emitting layer are anisotropic.

6. The organic light emitting device according to claim 5, wherein said exciton dipole moments of the organic molecules in the dipole controlled organic light emitting layer are substantially oriented within an angular range from 0 to 15 degrees with respect to an extending direction of the first electrode.

7. The organic light emitting device according to claim 5, wherein said exciton dipole moments of the organic molecules in the dipole controlled organic light emitting layer are substantially parallel to the first electrode.

8. The organic light emitting device according to claim 5, wherein said exciton dipole moments of the organic molecules in the dipole controlled organic light emitting layer are anisotropically arranged as a pattern with rows in parallel, a pattern with columns in parallel, an array of matrix, a radiation pattern, or a spiral pattern.

9. The organic light emitting device according to claim 5, wherein an angle of said longest axes of the organic molecules with respect to an extending direction of the first electrode is different from an angle of said exciton dipole moments of the organic molecules with respect to the extending direction of the first electrode.

10. The organic light emitting device according to any one of claims 1 to 9, wherein the first electrode is formed on a substrate and the second electrode is formed on the dipole controlled organic light emitting layer, and the organic light emitting device further comprises an electron-transporting layer (ETL) formed between the second electrode and the dipole controlled organic light emitting layer, wherein the ETL has a thickness in a range of about 2 nm to about 200 nm.

11. The organic light emitting device according to claim 10, wherein the substrate has a high refractive index n equal to or larger than 1.9.

12. The organic light emitting device according to claim 10 or 11, further comprising a light dispersion layer laminated on one side of the substrate opposite to the first electrode, wherein the light dispersion layer comprises an array of micro-optical components.

13. The organic light emitting device according to any one of claims 10 to 12, wherein one side of the substrate is a light dispersion plane comprising a plurality of micro-optical components

14. The organic light emitting device according to any one of claims 10 to 13, further comprising an intermediate layer disposed between the substrate and the first electrode, and a plurality of light-scattering particles distributed in the intermediate layer.

15. The organic light emitting device according to any one of claims 1 to 14, further comprising a periodic array of nano-grating structure formed between the first electrode and the second electrode, wherein the periodic array of nano-grating structure inhibits generation and propagation of TM polarized light, and the periodic array of nano-grating structure allows TE polarized light to propagate into the periodic array of nano-grating structure and through the dipole controlled organic light emitting layer.
